Europäisches Patentamt

(19) European Patent Office

Office européen des brevets

(11) Publication number: **0 152 625 B1**

# EUROPEAN PATENT SPECIFICATION

(45) Date of publication of patent specification: **06.05.92**

(51) Int. Cl.⁵: **H01L 29/04**, H01L 29/78, H01L 21/72

(21) Application number: **84116302.5**

(22) Date of filing: **24.12.84**

(54) Method for fabricating a semiconductor device having a polycrystalline silicon-active region.

(30) Priority: **23.12.83 JP 251813/83**
**24.05.84 JP 105192/84**

(43) Date of publication of application:
**28.08.85 Bulletin 85/35**

(45) Publication of the grant of the patent:
**06.05.92 Bulletin 92/19**

(84) Designated Contracting States:
**DE FR GB NL**

(56) References cited:
**EP-A- 0 051 396**

**APPLIED PHYSICS LETTERS, vol. 42, no. 8, 15th April 1983, pages 701-703, American Institute of Physics, New York, US; Y. HIRAI et al.: "Glow discharge polycrystalline silicon thin-film transistors"**

**PROCEEDINGS OF THE IEEE, vol. 71, no. 5, May 1983, pages 657-666, New York, US; M.C. PECKERAR et al.: "High-speed microelectronics for military applications"**

**INTERNATIONAL ELECTRON DEVICES MEET-**

**ING, Technical Digest, Washington, D.C., 3rd-5th December 1979, pages 510-513, IEEE, New York, US; P.M. SOLOMON et al.: "A poly-silicon base bipolar transistor"**

**PATENT ABSTRACTS OF JAPAN, vol. 9, no. 248 (E-347)[1971], 4th October 1985; & JP-A-60 98 680**

**Jap Jour, Applied Physics, vol 23 no. 11 nov 1984, pp.L819-L820 Proc. IEDM, L.A. , Dec 7-10, 1986, p. 196-199.**

(73) Proprietor: **SONY CORPORATION**
**7-35 Kitashinagawa 6-Chome Shinagawa-ku Tokyo 141(JP)**

(72) Inventor: **Hayashi, Hisao**
**c/o Sony Corporation 7-35 Kitashinagawa 6-chome**
**Shinagawa-ku Tokyo(JP)**

(74) Representative: **TER MEER - MÜLLER - STEIN-MEISTER & PARTNER**
**Mauerkircherstrasse 45**
**W-8000 München 80(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(−/2.18/2.0)

## Description

The present invention relates generally to a method for fabricating a semiconductor device, such as a field-effect transistor (FET) or a MOS thin-film transistor (MOS TFT). More particularly the invention relates to a method for fabricating a semiconductor device having a polycrystalline or amorphous silicon layer acting as an active region with high effective mobility, relatively low threshold voltage, and low leakage current between the source region and the drain region when used in MOS TFT.

It has been known for example from: Applied Physics Letters, Vol 42, No. 8, April 15, 1983, pages 701-703 that semiconductor devices with polycrystalline silicon active regions formed by chemical vapor deposition processes and the like are less efficient than semiconductor devices with single-crystal silicon active regions due to relatively low effective mobility, relatively high threshold voltage, and relatively high leakage current while the MOS TFT is turned OFF. This is believed to be due to the characteristics of the polycrystalline silicon layer serving as the active region.

The inventor has found that the effective mobility $\mu_{eff}$ of the polycrystalline silicon film is significantly enhanced within a specific thickness range. Specifically, when the thickness of the polycrystalline silicon film is held to within a specific range thinner than that conventionally employed in semiconductor devices, its effective mobility becomes much higher than typically expected. This fact has not been exploited before because it has generally been believed that the effective mobility of a thin polysilicon film is almost independent of thickness in films thinner than 1500Å i.e. 150 nm since 10Å = 1nm. The results of experiments by the inventor indicate that effective mobility becomes much greater than conventionally assumed in a range of thickness far thinner than is used conventionally.

The inventor has also found that if the effective mobility of the polycrystalline silicon film is sufficiently great, a thin film of polycrystalline silicon can be used to simplify the geometry and fabrication of complementary MOS (C-MOS) integrated circuits and so facilitate, for example, the fabrication of high-density C-MOS inverters.

## SUMMARY OF THE INVENTION

Therefore, it is an object of the present invention to provide a method for fabricating a semiconductor device with a thin polycrystalline silicon film serving as an active region which has an effective mobility matching that of single-crystal silicon.

Another and more specific object of the present invention is to provide a method for fabricating a semiconductor device having an active region made of polycrystalline silicon film of a specific thickness, specifically significantly thinner than conventional devices.

A further object of the invention is to provide a method for fabricating a high-density C-MOS integrated inverter circuit employing a polycrystalline silicon thin film.

In order to accomplish the aforementioned objects, a method according to the present invention, is characterised by: adjusting a desired thickness of the polycrystalline silicon layer to be in the range of 10nm ≤ d ≤ 75 nm, implanting into said polycrystalline silicon layer ions from the same group of elements of the periodic table and annealing said layer. According to another aspect of the invention amorphous silicon for producing said silicon layer is deposited prior to the adjustment of the thickness of the silicon layer.

In a preferred embodiment, the thickness of the thin layer falls in the range of approximately 100Å to 750Å. More preferably, the thickness of the thin layer is in the range of approximately 100Å to 600Å. In the present invention, the effective mobility is optimized in the thickness range of 200Å to 500Å.

The present invention also provides for a high-density C-MOS inverter IC employing the polycrystalline silicon layer deposited on a semiconductor substrate over an insulating layer.

The polycrystalline silicon layer deposited on the semiconductor substrate serves as an active region of the semiconductor device and has a thickness in a specific thickness range in which the polycrystalline silicon layer exhibits a sufficiently high effective carrier mobility and a sufficiently low threshold voltage.

A field effect transistor produced according to the invention comprises a semiconductor substrate, a polycrystalline silicon active layer formed on the substrate, the active layer having a thickness in the range of 100Å to 750Å and a source region and a drain region formed therein, a gate electrode formed on the polycrystalline silicon layer over an insulating layer, and electrically conductive input/output terminals in contact with the source region and the drain region.

An IC chip comprises a semiconductor substrate, an insulating layer formed on the substrate, a polycrystalline silicon layer formed over the substrate and the insulating layer, a first semiconductor device of a first conductivity type formed on the polycrystalline silicon layer, and a second semiconductor device of a second, opposing conductivity type formed on the polycrystalline silicon layer.

## BRIEF DESCRIPTION OF THE DRAWINGS

The present invention will be understood more fully from the detailed description given herebelow and from the accompanying drawings of the preferred embodiments of the invention, which, however, should not be taken to limit the invention to the specific embodiments but are for explanation and understanding only.

In the drawings:

Fig. 1 is a cross-section of a MOS TFT produced in accordance with the present invention;

Fig. 2 is a graph of the relationship between effective mobility $\mu_{eff}$ and the thickness of the polycrystalline silicon film serving as the active region of the MOS TFT of Fig. 1; and

Figs. 3(A) to 3(E) are cross-sections through a C-MOS inverter IC at five stages of its fabrication.

## DESCRIPTION OF THE PREFERRED EMBODIMENT

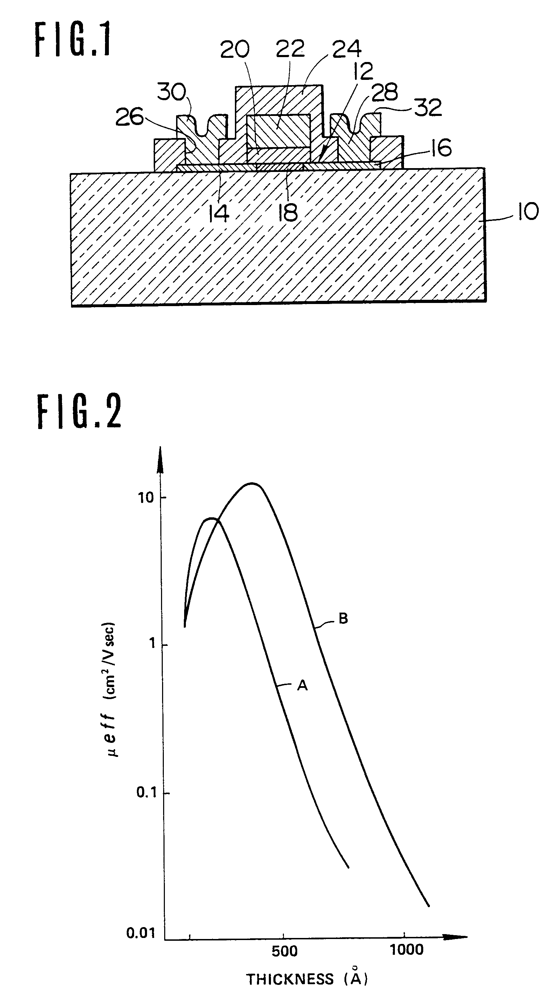

Referring now to the drawings, Fig. 1 shows a MOS thin film transistor which will be referred to hereafter as "MOS TFT". According to the invention, a thin polycrystalline silicon layer 12 is formed on a quartz substrate 10. The polycrystalline silicon layer 12 has n-type regions 14 and 16 at either end, where it is heavily doped with n-type impurities so as to have a relatively low resistance to electron conduction. The n-type regions 14 and 16 respectively form a source region and a drain region. The central section of the polycrystalline silicon layer defines a channel between the source region 14 and the drain region 16 and serves as an active region 18.

A gate insulating layer 20 made of silicon dioxide ($SiO_2$) is deposited on the polycrystalline silicon layer 12 so as to cover the active region 18. A highly doped polycrystalline silicon (DOPOS) gate electrode 22 is deposited over the gate insulator 20. The gate electrode 22 is covered with a silicon dioxide layer acting as an insulator 24. The insulator 24 is formed with openings 26 and 28 through which connector electrodes 30 and 32 are formed in contact with the source and drain regions 14 and 16 respectively. Although it not clearly illustrated in the drawing, the gate electrode 22 is also connected to a connector electrode fabricated in a per se well-known manner.

According to the preferred embodiment, the thickness t of the polycrystalline layer 12 is adjusted to be in the range of 100Å to 750Å, preferably about 200Å. This preferred thickness range has been derived empirically from experiments performed by the inventor with polycrystalline silicon layers of various thicknesses. The results of these experiments are illustrated in Fig. 2.

As will be seen from Fig. 2, the effective mobility $\mu_{eff}$ of the polycrystalline silicon active region increases significantly as the thickness drops from about 1000Å to about 200-500Å. As the thickness of the polycrystalline silicon layer drops below 200Å, the mobility decreases at a relatively high rate. Also, as shown in Fig. 2, the effective mobility $\mu_{eff}$ of the polycrystalline silicon layer is maximized at a thickness of about 200-500Å.

In Fig. 2, curve A shows the behavior of the effective mobility of a polycrystalline silicon layer which is formed directly into the desired thickness by the process of chemical vapor deposition. On the other hand, curve B represents the characteristics of the effective mobility of a polycrystalline silicon layer which is first formed by chemical vapor deposition to a greater than desired thickness and then reduced to its final desired thickness by thermal oxidation. In experiments involving samples A, a maximum effective mobility of 7.2 $cm^2/V$ sec was achieved at a thickness of 210Å. On the other hand, experiments with samples B revealed a maximum effective mobility of 12 $cm^2/V$ sec at the thickness of 370Å.

In the shown embodiment, the thickness of the polycrystalline silicon active region is chosen to be 200Å, and so the effective mobility of an active region of type A will be about 7 $cm^2/V$ sec and in a circuit employing a layer of type B, about 5 $cm^2/V$ sec. Therefore, it should be appreciated that the mobility of the polycrystalline silicon layer according to the shown embodiment will be significantly higher than conventional polycrystalline silicon layers. Since the production costs of a polycrystalline silicon layer are much lower than for a single-crystal silicon layer, the overall production cost of MOS TFT's employing the invention can be reduced without sacrificing any of the functional advantages of a single-crystal silicon active region.

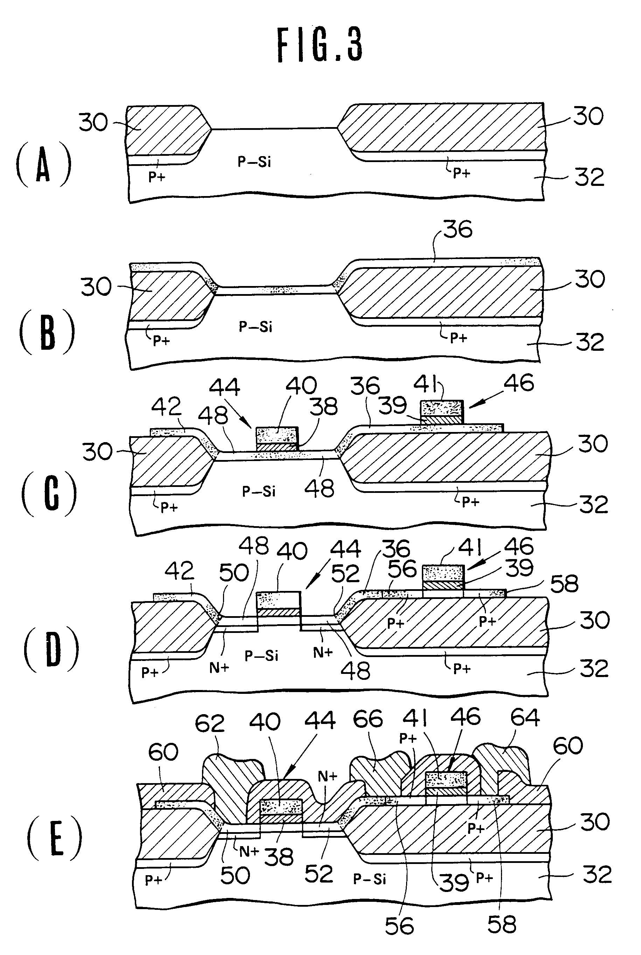

Figs. 3(A) to 3(E) show a sequence of process steps during fabrication of a C-MOS inverter. The thin polycrystalline silicon layer is used to good effect in simplifying fabrication of the C-MOS inverter.

Fig. 3(A) shows the initial stage of fabrication of the C-MOS inverter. Field $SiO_2$ layers 30 are formed on a P-type Si substrate 32 by localized oxidation of silicon (LOCOS). LOCOS is carried out over most of the substrate 32, excluding only the section on which a MOS transistor is to be formed. Thereafter, a layer 36 of polysilicon or amorphous silicon is deposited over the entire surface by chemical vapor deposition.

Si$^+$ or Ge$^+$ ion implantation and annealing for 15 hours at a temperature of 600°C follow deposition of polycrystalline silicon or amorphous silicon in the step shown in Fig. 3(B).

In the preferred embodiment, the thickness of the deposited polycrystalline silicon layer falls in the range of 100Å to 750Å, and preferably in the range of 200Å to 500Å. Holding the polysilicon layer to the preferred range of thickness ensures that the effective mobility will be adequately high and the leakage current will be acceptably low.

After performing the process shown in Fig. 3-(B), the sections of the polycrystalline silicon layer formed on the field SiO$_2$ layer, appearing at the edges of Fig. 3(B), are removed, as shown in Fig. 3(C). Gate oxide layers 38 and 39 and gate electrodes 40 and 41 are formed at points on the polycrystalline silicon layer 36 at which an N-channel MOS drive transistor 44 and a P-type MOS load transistor 46 are to be formed.

N-type ion implantation is performed on the section 48 of the polycrystalline silicon layer 42 on which the N-channel MOS drive transistor 44 is to be formed, as shown in Fig. 3(D). The resulting N + regions to either side of the gate 40 serve as source region 50 and drain region 52 of the NMOS drive transistor 44. Similarly, P-type ion implantation is performed at the site of the P-channel MOS load transistor 46 to form its source region 56 and drain region 58. After this step, a relatively thick layer 60 of SiO$_2$ is deposited over the entire surface of the IC for insulation. Contact windows are etched through the oxide layer 60 through which a source electrode 62, a drain electrode 64 and a bridging electrode 66 which bridges between the drain region 52 of N-channel MOS drive transistor and the source region 56 of the P-channel MOS load transistor can contact the corresponding doped regions 50, 58, and 52/56, as shown in Fig. 3-(E).

With the shown geometry, since the section of the polycrystalline silicon layer 42 directly below the gate oxide 38 is in direct contact with the single-crystal silicon substrate, the crystal grains of the vapor-deposited polysilicon layer 36 will tend to grow large enough to minimize the effect of carrier traps along grain boundaries. Furthermore, if an additional annealing step is added following the Si$^+$ or Ge$^+$ ion implantation process, the polysilicon layer may fully recrystallize into a single-crystal silicon layer. In either case, the source region and the drain region formed in the polycrystalline silicon layer will have a sufficiently high effective mobility.

According to the shown embodiment, the fabrication process for a C-MOS inverter can be significantly simplified. In particular, as set forth above, the polycrystalline silicon layer is deposited onto the areas of the substrate on which the N-channel MOS drive transistor and the P-channel MOS load transistor are to be formed prior to formation of the N-channel MOS drive transistor which is conventionally formed directly on the single-crystal silicon substrate. This allows both of the aforementioned transistors to be formed at the same time in a single step following vapor-deposition of the polycrystalline silicon layer, which has conventionally required at least two separate, independent steps. Furthermore, as the source regions and drain regions of the N-channel MOS drive transistor and P-channel MOS load transistor are formed in the same polycrystalline silicon layer, connection of the drain region of the N-channel MOS drive transistor to the source region of the P-channel MOS load transistor is greatly facilitated, in that the adjoining drain and source regions can be connected simply by means of the single bridging electrode. Additionally, since the gate electrodes for both of the transistors can be formed in a single step and at the same time, connecting the transistors to each other requires only a single photolithographic step and so obviates the need for the additional steps needed in fabrication of conventional transistors. Furthermore, since the source regions and drain regions may extend over wider areas than in conventional devices, the contact windows need not be as finely delineated, which further expedites the fabrication process.

As mentioned above Fig. 3(B) includes the Si$^+$ or Ge$^+$ ion implantation and annealing steps.

The Si$^+$ or Ge$^+$ ion implantation is performed following the step of depositing polycrystalline silicon or amorphous silicon on the P-type silicon substrate. Following ion implantation, annealing is performed for 15 hours at a temperature of approximately 600°C. This improves mobility characteristics of the polycrystalline silicon layer significantly. Specifically, the ion implantation and annealing steps increases the average polysilicon grain size in sections where the polysilicon layer is in contact with the single crystal layer to the point where the layer 36 may be traversed by single crystal grains, which makes the properties thereof essentially identical to single-crystal silicon.

Although the illustrated embodiment concerns an N-channel MOS transistor on a P-type substrate and a P-channel MOS transistor on a field SiO$_2$ layer, it would be possible to form a P-channel MOS transistor on an N-type silicon substrate and an N-channel MOS transistor on the field SiO$_2$ layer.

## Claims

1. A method of fabricating a semiconductor device comprising the step of depositing a polycrystalline silicon layer (12) serving as an active region in the semiconductor device onto a semiconductor substrate (10), **characterized by:**
   - adjusting a desired thickness (d) of the polycrystalline silicon layer (12) to be in the range of

     10 nm ≤ d ≤ 75 nm.
   - implanting into said polycrystalline silicon layer (12) ions from the same group of elements of the periodic table and
   - annealing said layer (12).

2. A method of fabricating a semiconductor device comprising the step of depositing a silicon layer(12) serving as an active region of the semiconductor device onto a semiconductor substrate (10), **characterized by**
   - depositing amorphous silicon for producing said silicon layer (12),
   - adjusting a desired thickness (d) of said silicon layer (12) to be in the range of

     10 nm ≤ d ≤ 75 nm.
   - implanting into said silicon layer (12) ions from the same group of elements of the periodic table and
   - annealing said layer (12).

3. The method as claimed in claim 1 or 2, **characterized in that** the ions are $Si^+$ or $Ge^+$ ions.

4. The method as claimed in claim 1, 2 or 3, **characterized in that** the step of adjusting the desired thickness (d) comprises the steps of:
   - depositing silicon to a thickness greater than that required in the finished semiconductor device and
   - thermally oxidizing the deposited silicon layer (12) to obtain the desired thickness (d).

5. The method as claimed in one of the claims 1 to 4, **characterized in that** said silicon layer (12) is formed by the process of chemical vapor deposition.

6. The method as claimed in one of the claims 1 to 5, **characterized in that** the desired thickness (d) is in the range of

   20 nm ≤ d ≤ 50 nm.

## Revendications

1. Procédé de fabrication d'un dispositif à semiconducteur comprenant l'étape de dépôt d'une couche en silicium polycristallin (12) servant de région active dans le dispositif à semiconducteur sur un substrat semiconducteur (10), caractérisé par :
   l'ajustement d'une épaisseur souhaitée (d) de la couche en silicium polycristallin (12) de manière à ce qu'elle s'inscrive dans la plage définie par :

   10 nm ≤ d ≤ 75 nm ;

   l'implantation dans ladite couche en silicium polycristallin (12) d'ions en provenance du même groupe d'éléments du tableau périodique des éléments ; et
   le recuit de ladite couche (12).

2. Procédé de fabrication d'un dispositif à semiconducteur comprenant l'étape de dépôt d'une couche en silicium (12) servant de région active dans le dispositif à semiconducteur sur un substrat semiconducteur (10), caractérisé par :
   le dépôt de silicium amorphe pour produire ladite couche de silicium (12) ;
   l'ajustement d'une épaisseur souhaitée (d) de la couche en silicium (12) de manière à ce qu'elle s'inscrive dans la plage définie par :

   10 nm ≤ d ≤ 75 nm ;

   l'implantation dans ladite couche en silicium (12) d'ions en provenance du même groupe d'éléments du tableau périodique des éléments ; et
   le recuit de ladite couche (12).

3. Procédé selon la revendication 1 ou 2, caractérisé en ce que les ions sont des ions $Si^+$ ou $Ge^+$.

4. Procédé selon la revendication 1, 2 ou 3, caractérisé en ce que l'étape d'ajustement de l'épaisseur souhaitée (d) comprend les étapes de :
   dépôt de silicium selon une épaisseur supérieure à celle nécessaire dans le dispositif à semiconducteur fini ; et

oxydation thermique de la couche de silicium déposée (12) afin d'obtenir l'épaisseur souhaitée ( d).

5. Procédé selon l'une quelconque des revendications 1 à 4, caractérisé en ce que ladite couche en silicium (12) est formée au moyen du procédé de dépôt chimique en phase vapeur.

6. Procédé selon l'une quelconque des revendications 1 à 5, caractérisé en ce que l'épaisseur souhaitée (d) s'inscrit dans la plage :

20 nm ≤ d ≤ 50 nm.

**Patentansprüche**

1. Verfahren zur Herstellung einer Halbleiteranordnung, bei dem eine polykristalline Siliziumschicht (12), die als aktiver Bereich in der Halbleiteranordnung dient, auf ein Halbleitersubstrat (10) aufgebracht wird, **gekennzeichnet durch:**
   - Einstellen einer gewünschten Dicke (d) der polykristallinen Siliziumschicht (12) auf einen Wert im Bereich von

     10 nm ≤ d ≤ 75 nm,

   - in die polykristalline Siliziumschicht (12) werden Ionen aus derselben Gruppe von Elementen des Periodensystems implantiert,
   - die Schicht (12) wird getempert.

2. Verfahren zur Herstellung einer Halbleiteranordnung, bei dem eine Siliziumschicht (12), die als aktiver Bereich in der Halbleiteranordnung dient, auf ein Halbleitersubstrat (10) aufgebracht wird, **gekennzeichnet durch:**
   - Niederschlagen von amorphem Silizium zur Herstellung der Siliziumschicht (12),
   - Einstellen einer gewünschten Dicke (d) der Siliziumschicht (12) auf einen Wert im Bereich von

     10 nm ≤ d ≤ 75 nm,

   - in die Siliziumschicht (12) werden Ionen aus derselben Gruppe von Elementen des Periodensystems implantiert,
   - die Schicht (12) wird getempert.

3. Verfahren nach Anspruch 1 oder 2, **dadurch gekennzeichnet,** daß die Ionen $Si^+$ oder $GE^+$ Ionen sind.

4. Verfahren nach Anspruch 1, 2 oder 3, **dadurch gekennzeichnet,** daß der Schritt zur Einstellung der gewünschten Dicke (d) folgende Schritte enthält:
   - Niederschlagen von Silizium bis zu einer Dicke, die größer ist als die, die in der fertigen Halbleiteranordnung erforderlich ist,
   - thermische Oxidierung der niedergeschlagenen Siliziumschicht (12) zur Erzielung der gewünschten Dicke (d).

5. Verfahren nach einem der Ansprüche 1 bis 4, **dadurch gekennzeichnet,** daß die Siliziumschicht (12) durch einen Chemical Vapor Deposition Prozeß gebildet wird.

6. Verfahren nach einem der Ansprüche 1 bis 5, **dadurch gekennzeichnet,** daß die gewünschte Dicke im Bereich von

   20 nm ≤ d ≤ 50 nm

   liegt.

# FIG.1

# FIG.2

μ eff (cm²/V sec)

THICKNESS (Å)

# FIG.3